# EUROPÄISCHE PATENTSCHRIFT

(11) **EP 0 566 639 B1**
(45) Veröffentlichungstag und Bekanntmachung des Hinweises auf die Patenterteilung: **22.04.1998**
(21) Anmeldenummer: 92903190.4
(22) Anmeldetag: 07.01.1992
(51) Int. Cl.: H01L 29/74, H01L 29/745

(54) **INTEGRIERTE LEISTUNGSSCHALTERSTRUKTUR**
INTEGRATED POWER SWITCH STRUCTURE
STRUCTURE INTEGREE D'UN INTERRUPTEUR DE PUISSANCE

(30) Priorität: 09.01.1991 DE 4100444
(43) Veröffentlichungstag der Anmeldung: 27.10.1993
(73) Patentinhaber: FRAUNHOFER-GESELLSCHAFT ZUR FÖRDERUNG DER ANGEWANDTEN FORSCHUNG E.V., 80636 München (DE)
(72) Erfinder: MÜTTERLEIN, Bernward, 47057 Duisburg (DE); VOGT, Holger, 45481 Mülheim (DE)
(74) Vertreter: Schoppe, Fritz, Dipl.-Ing.
(86) Internationale Anmeldenummer: DE9200011
(87) Internationale Veröffentlichungsnummer: WO9212541

(56) Entgegenhaltungen:
- EP-A- 477 594
- WO-A-90/10311
- US-A- 4 847 671

## Beschreibung

Die vorliegende Erfindung betrifft eine integrierte Leistungsschalterstruktur mit einem von einem lateralen MOS-Gate gesteuerten lateralen oder vertikalen Thyristor, bei der das laterale MOS-Gate mit seiner Drain-Source-Strecke in Reihe zu der Kathoden-Anoden-Strecke des Thyristors liegt, nach dem Oberbegriff des Patentanspruchs 1.

Allgemein befaßt sich die Erfindung mit der Verbesserung einer Leistungsschalterstruktur, die sich zum Schalten großer Lasten eignet.

Zum Schalten großer Lasten werden Leistungs-DMOS-Transistoren für den Bereich niedriger Spannungen von weniger als 100 V auch bei hohen Strömen oberhalb von 10 A als ideale Schaltelemente angesehen. Ein Leistungs-DMOS-Transistor hat im eingeschalteten Zustand einen niedrigen Widerstand und ermöglicht ein schnelles Einschalten bzw. Ausschalten. Bei höheren Spannungen im Bereich zwischen 500 V und 1500 V wird bei Leistungs-DMOS-Transistoren das Produkt aus dem Einschaltwiderstand und der Fläche, das ein wesentliches Maß für die Güte des Bauelementes ist, immer größer und somit immer nachteiliger.

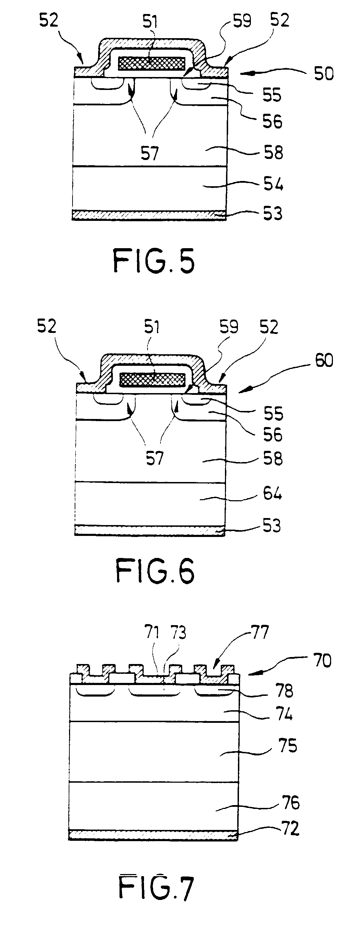

Nachfolgend wird anhand der Darstellung eines bekannten Leistungs-DMOS-Transistors, der in Fig. 5 in seiner Gesamtheit mit dem Bezugszeichen 50 bezeichnet ist, der Grund für die mit höheren, zu schaltenden Spannungen nachlassende Bauelementegüte erläutert. Wie gezeigt ist, umfaßt ein derartiger DMOS-Transistor 50 ein Gate 51, eine Sourceelektrode 52 und eine Drainelektrode 53, welche an ein n⁺-Substrat 54 anschließt. Bei den Source-Elektroden-Bereichen 52 weist der bekannte Leistungs-DMOS-Transistor 50 jeweils einen n⁺-Bereich 55 auf, der von einem p-Basisbereich 56 umschlossen ist. Zwischen dem n⁺-Substrat 54 und den p-Basisbereichen 56 liegt ein n-Driftbereich 58, der durch eine niedrig dotierte, epitaktisch auf das hochdotierte n⁺-Siliziumsubstrat 54 aufgewachsene Halbleiterschicht gebildet wird. Die Spannungsfestigkeit des bekannten DMOS-Transistors 50 wird mit der Raumladungszone eines pn-Überganges eingestellt, der sich in die epitaktisch aufgewachsene Halbleiterschicht 58 erstreckt. Je weiter die Raumladungszone sich ausdehne kann, d. h. je größer die epitaktisch aufgewachsene Schicht 58 ist und je niedriger ihre Dotierung ist, desto höher ist die Spannungsfestigkeit des DMOS-Transistors 50. Andererseits nimmt der Einschaltwiderstand mit größer werdender Driftstrecke und niedriger werdender Dotierung zu, da der Strom die epitaktisch aufgewachsene Schicht 58 durchqueren muß.

Um den Epitaxiewiderstand zu vermindern, bedient man sich in der Leistungselektronik auch eines sogenannten IGBT (Insulated Gate Bipolar Transistor) bzw. IGT, wie er in Fig. 6 dargestellt ist und in seiner Gesamtheit mit dem Bezugszeichen 60 bezeichnet ist. Mit Ausnahme der nachfolgend erläuterten Unterschiede stimmt dieser strukturell mit dem unter Bezugnahme auf Fig. 5 erläuterten DMOS-Transistor 50 überein, wobei gleiche Teile und Bereiche mit gleichen Bezugszeichen bezeichnet sind. Bei dem IGBT 60 gemäß Fig. 6 ist das n⁺-Substrat 54 des DMOS-Transistors 50 nach Fig. 5 durch ein ebenso hoch dotiertes p⁺-Substrat 64 ersetzt. Der sich ergebende pn-Übergang zwischen dem Substrat 64 und der epitaktisch aufgewachsenen Schicht 58 liegt im eingeschalteten Zustand in Durchlaßrichtung gepolt in Reihe zu dem eigentlichen Transistor und injiziert eine große Anzahl von Minoritätsträgern, d.h. Löchern, in die epitaktisch aufgewachsene Schicht 58. Hierdurch reduziert sich deren Widerstand drastisch um ein bis zwei Größenordnungen verglichen mit dem Epitaxiewiderstand des DMOS-Transistors 50 gemäß Fig. 5. Jedoch ist es erforderlich, die Ladungsträgerinjektion zu begrenzen, da anderenfalls ein parasitärer p⁺n⁻pn⁺-Thyristor zündet, so daß der Strom durch den IGBT 60 nicht mehr durch das MOS-Gate 51 gesteuert werden kann. Diese Steuerung hat aen Vorteil, daß sie kapazitiv über eine Isolatorschicht 59 erfolgt und somit keine statische Verlustleistung erzeugt. Nur zum Umschalten des Transistors von dem gesperrten Zustand in den leitenden Zustand oder umgekehrt fließt ein Ladestrom.

Fig. 7 zeigt eine weitere, bekannte Leistungsschalterstruktur in Form eines Thyristors (GTO), der in seiner Gesamtheit mit dem Bezugszeichen 70 bezeichnet ist. Der bekannte Thyristor 70 hat eine Kathode 71, eine Anode 72, sowie zwischen der Kathode 71 und Anode 72 eine übliche n⁺pnp⁺-Vierschichtenstruktur mit einer n⁺-Schicht 73, einer p-Basisschicht 74, einer n-Basisschicht 75 und einem p⁺-Substrat 76. Ferner umfaßt dieser bekannte Thyristor ein Ansteuerungs-Gate 77, das mit einer p⁺-Schicht 78 an die p-Basisschicht 74 angrenzt, so daß es möglich ist, diesen Thyristor durch Anlegen eines negativen Stromes an das Gate 77 auszuschalten.

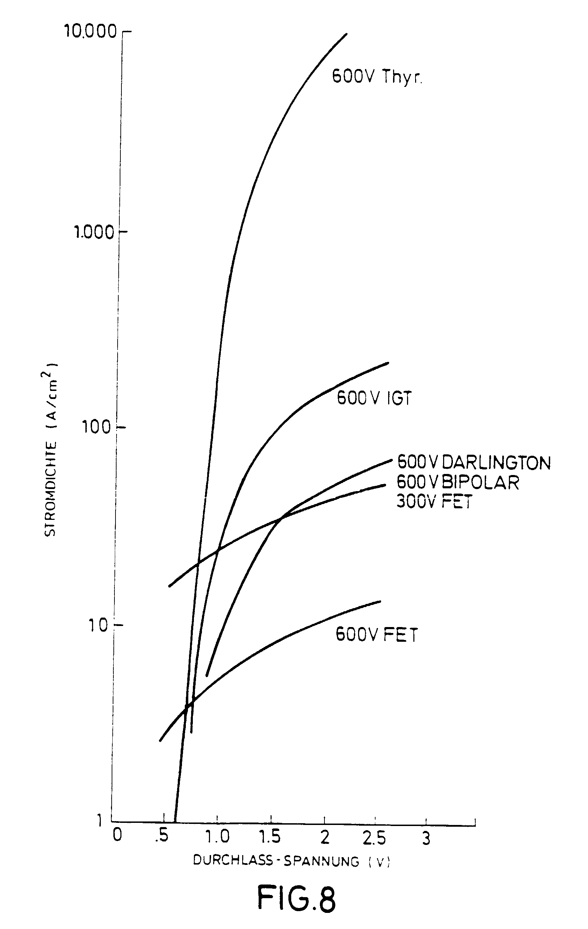

Fig. 8 zeigt typische Abhängigkeiten der Durchlaßspannung von der Stromdichte für folgende Leistungsschalterelemente: einen FET mit 600 V Sperrspannung, einen FET mit 300 V Sperrspannung, einen Bipolartransistor mit 600 V Sperrspannung, einen Darlingtontransistor mit 600 V Sperrspannung, einen IGT mit 600 V Sperrspannung sowie einen Thyristor mit derselben Sperrspannung. Wie aus der Gegenüberstellung von Fig. 8 ohne weiteres erkennbar ist, hat der Thyristor bei gleicher Durchlaßspannung den bei weitem höchsten Strom bezogen auf die Chipfläche. Nachteilig ist es jedoch bei üblichen ausschaltbaren Thyristoren, daß diese einen vergleichsweise hohen Ausschaltstrom erfordern, der mehr als 1/10 des Laststromes betragen muß.

Es wurden daher bereits Untersuchungen angestellt, die über ein MOS-Gate ein- und ausschaltbare Thyristoren betreffen, um die Nachteile der oben erläuterten Leistungsschalterstrukturen nach dem Stand der Technik auszuräumen.

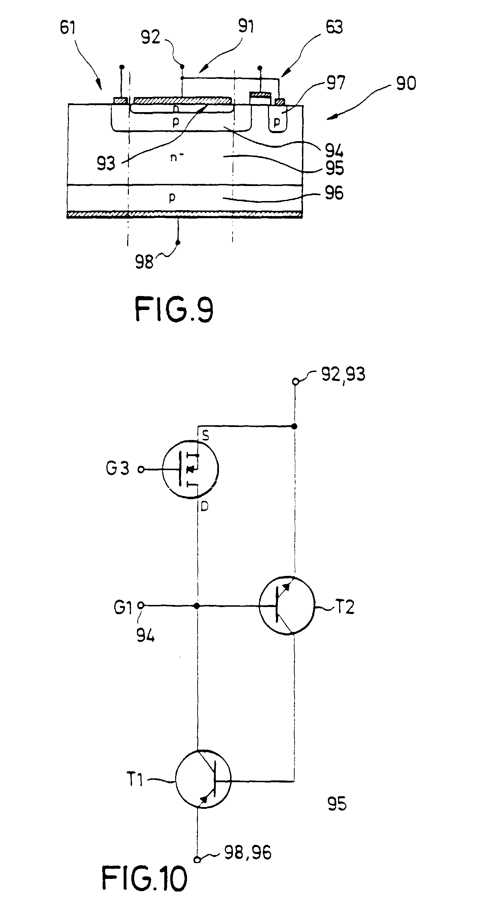

So ist aus der Fachveröffentlichung W. Seifert und A. A. Jaecklin: An FET-Driven Power Thyristor, IEEE Trans. Elec. Dev., Band ED-34, Nr. 5, 1987, Seiten 1170 bis 1176 eine integrierte Leistungsschalterstruktur mit einem von einem lateralen MOS-Gate gesteuerten vertikalen Thyristor bekannt. Diese bekannte Leistungsschalterstruktur ist in Fig. 9 gezeigt. Die Struktur umfaßt drei Bereiche, nämlich in Fig. 9 linksseitig ein erstes Gate G1, rechtsseitig das laterale MOS-Gate G3 sowie im Mittenbereich der Thyristor, der mit dem Bezugszeichen 91 bezeichnet ist. Der Thyristor umfaßt eine Kathode 92, eine Anode 98 und eine sich zwischen diesen erstreckende n⁺pnp⁺-Vierschichtenfolge bestehend aus der n⁺-Schicht 93, der p-Basisschicht 94, der n-Basisschicht 95 und dem p⁺-Substratbereich 96. An dem Anodenanschluß 98 liegt eine positive Spannung, während an dem Kathodenanschluß 92 eine negative Spannung angelegt ist. Der Kathodenanschluß 92 ist ferner mit einem p-dotierten Bereich 97 des lateralen MOS-FET G3, 94, 95, 97 verbunden, welcher dessen Sourceelektrode bildet. Die Drainelektrode dieses lateralen MOS-FET steht mit der p-Basisschicht 94 in Verbindung bzw. wird durch diese definiert.

Über das erste Gate G1 können bei positiver Gatespannung Elektronen von der Kathode 92 in die epitaktisch aufgewachsene Schicht 95 injiziert werden. Die Epi-Schicht ist, wie in Fig. 10 gezeigt ist, die Basis eines pnp-Transistors T1, der diesen Strom verstärkt und Löcher in die p-Schicht 94 sendet. Diese p-Schicht 94 bildet die Basis eines npn-Transistors T2, der den Strom weiterverstärkt und noch mehr Elektronen in die Epi-Schicht 95 schickt. Die rückgekoppelten Transistoren T1, T2 bewirken ein Ansteigen des Stromes, so daß der Thyristor 91 durchschaltet und niederohmig wird. Erst bei Anlegen einer stark negativen Spannung an das MOS-Gate G3 sperrt der Thyristor 91 wieder, da über den durch das MOS-Gate G3 aufgesteuerten lateralen PMOS-Transistor 94, 95, 97 ein Teil des npn-Basisstromes zu der Thyristor-kathode 92 kurzgeschlossen wird.

Diese Abschaltmöglichkeit ist jedoch begrenzt. Übersteigt der Strom im Thyristor einen bestimmten Wert, so kann über den PMOS-Transistor 94, 95, 97 nicht mehr genügend Strom abgeführt werden, so daß der Thyristor eingeschaltet bleibt. Die Ausschaltmöglichkeit ist also arbeitspunktabhängig und stellt einen nicht zulässigen Unsicherheitsfaktor dar.

Aus der WO-A-9010311 ist bereits eine Leistungsschalterstruktur bekannt, die einen Thyristor und einen lateralen MOS-Transistor aufweist. Diese integrierte Leistungsschalterstruktur stimmt weitgehend mit der soeben unter Bezugnahme auf Fig. 9 beschriebenen Leistungsschalterstruktur überein. Der MOS-Transistor dient zum Abschalten des Thyristors, indem er über einen Nebenstrompfad die Basis des Thyristors mit der Kathode des Thyristors kurzschließt und somit den Basisstrom reduziert, wodurch der Thyristor abschaltet. Bei hohem Thyristorstrom kann ein Zustand auftreten, bei dem ein Abschalten nicht mehr möglich ist, da trotz durchgeschaltetem MOS-Transistor der Hauptstrompfad erhalten bleibt. Wie bereits unter Bezugnahme auf den Stand der Technik gemäß Fig. 9 dargelegt wurde, ist bei einer derartigen Leistungsschalterstruktur die Ausschaltmöglichkeit daher arbeitspunktabhängig. Insbesondere kann nicht sichergestellt werden, daß in einem Array derartiger Leistungsschaltermodule sich der Strom gleichmäßig verteilt.

Aus der EP-A-0219995 ist eine Leistungsschalterstruktur mit einem Thyristor bekannt, die einen Ausschalttransistor umfaßt, der zum Kurzschließen der Basis-Emitter-Strecke des Thyristors dient. Bezüglich der Nachteile derartiger Leistungsschalterstrukturen kann auf die obigen Ausführungen verwiesen werden.

Aus der älteren, nicht vorveröffentlichten EP-A-477594 ist eine Leistungsschalterstruktur mit einem abschaltbaren Thyristor bekannt, welcher über zwei FETs angesteuert wird. Der erste FET bildet einen Abschaltstrompfad von der Basis, die an das Emittergebiet angrenzt, zu einem Hauptanschluß des Thyristors. Der zweite FET verbindet das Emittergebiet mit dem Hauptanschluß. Unterhalb des zweiten FET ist eine Isolierschicht vorgesehen. Für die Ansteuerung der FETs bedarf es einer bipolaren Steuerspannung, so daß diese Leistungsschalterstruktur bei solchen Anwendungsfällen nicht eingesetzt werden kann, bei denen nur eine unipolare Ansteuerspannung zur Verfügung steht.

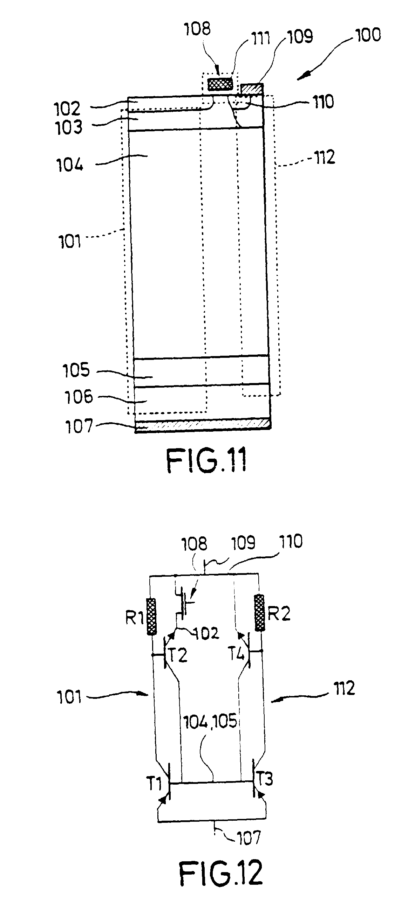

Aus der Fachveröffentlichung B. J. Baliga: The MOS-Gated Emitter Switched Thyristor, IEEE Elec. Dev. Lett., Band EDL-11, Nr. 2, 1990, Seiten 75 bis 77 ist eine integrierte Leistungsschalterstruktur der eingangs genannten Art mit einem von einem lateralen MOS-Gate gesteuerten vertikalen Thyristor bekannt, bei der das laterale MOS-Gate mit seiner Drain-Source-Strecke in Reihe zu der Kathoden-Anoden-Strecke des Thyristors liegt. Diese bekannte Leistungsschalterstruktur, welche in Fig. 11 gezeigt ist, ist dort in ihrer Gesamtheit mit dem Bezugszeichen 100 bezeichnet und umfaßt in ihrem linksseitigen Teil einen von einer gestrichelten Linie umfaßten Hauptthyristor 101 mit einer n⁺-Schicht 102, einer p-Basisschicht 103, einer n-Driftschicht 104, eine n-Pufferschicht 105, eine p⁺-Anodenschicht 106, an die eine Anode 107 anschließt. Die n⁺-Schicht 102 des vertikalen Thyristors oder Hauptthyristors 101 bildet gleichzeitig die Drainelektrode eines MOSFET 108, der lateral angeordnet ist. Die Kathode der Gesamtanordnung, die mit dem Bezugszeichen 109 bezeichnet ist, steht mit einem weiteren n⁺-Bereich 110 in Verbindung, der von dem n⁺-Bereich 102 durch einen dazwischenliegenden Bereich der p-Basisschicht 103 getrennt ist. Ein isoliertes Gate 111 des MOSFET 108 sperrt den Strom durch den MOS-Transistor, wenn es mit 0 V beaufschlagt wird. Die Sperrspannung dieser bekannten Leistungsschalterstruktur fällt über die Raumladungszone in der EP-Schicht 101, 105 ab.

Diese bekannte Leistungsschalterstruktur hat jedoch einen parasitären Thyristor 112, der durch die Vierschichtenfolge aus dem n-Bereich 110, der p-Basisschicht 103, der n-Driftschicht 104 sowie der n-Pufferschicht 105 und der p⁺-Anodenschicht 106 gebildet wird.

Das Ersatzschaltbild der Leistungsschalterstruktur gemäß Fig. 11 ist in Fig. 12 wiedergegeben. Mit Fig. 11 übereinstimmende Bezugszeichen bezeichnen gleiche Teile bzw. gleiche Bereiche. Der Hauptthyristor 101 gemäß Fig. 11 ist in dem Ersatzschaltbild von Fig. 12 durch die beiden Transistoren T1, T2 in Rückkopplungsschaltung wiedergegeben. Dementsprechend ist der parasitäre Thyristor 112 gemäß Fig. 11 in dem Ersatzschaltbild von Fig. 12 durch die beiden rückgekoppelt geschalteten Transistoren T3, T4 wiedergegeben. Wie man aus dem Ersatzschaltbild gemäß Fig. 12 erkennt, hat diese bekannte Thyristorstruktur bzw. Leistungsschalterstruktur den Nachteil, daß der parasitäre Thyristor 112 einen Stromfluß über die n⁺-Sourceelektrode des lateralen MOS-Transistors 108 ermöglicht. Dieser Strom ist nicht über das MOS-Gate 111 steuerbar und verhindert ein Abschalten des Thyristors, sobald dessen Strom einen bestimmten Wert übersteigt.

Daher zeigen die bekannten Leistungsschalterstrukturen nach den Fig. 9 bis 12, die als MOS-Gate steuerbare Thyristoren bezeichnet werden können, kein zufriedenstellendes Abschaltverhalten. Aus diesem Grunde sind diese bislang nur in der Literatur vorgeschlagenen Leistungsschalterstrukturen über ein Laborstadium bislang nicht hinausgekommen.

Aus DE 3905149 Al ist bereits eine Leistungsschaltung mit einer integrierten CMOS- oder Bipolar-Schaltung bekannt, bei der die CMOS- oder Bipolar-Schaltung auf einer Halbleitermaterialinsel angeordnet ist, die gegenüber dem angrenzenden Halbleitermaterial durch eine vergrabene Isolationsschicht sowie eine Dotierungsschicht, die entgegengesetzt zur EPI-Schicht dotiert ist, abgeschirmt ist.

Zum technologischen Hintergrund der Erfindung wird ferner auf folgende Schriften verwiesen:
- Solid State Electronics, Vol. 25, No. 5, 1982, S. 345 bis 353.
- EP 00 11 443 B1,
- DE 39 05 149 A1, und
- IEEE Electron Device Letters, Vol. 11, No. 2, Februar 1990, S. 75 bis 77.

Ausgehend von diesem Stand der Technik liegt der vorliegenden Erfindung die Aufgabe zugrunde, eine integrierte Leistungsschalterstruktur mit einem von einem lateralen MOS-Gate gesteuerten lateralen oder vertikalen Thyristor der eingangs genannten Art so weiterzubilden, daß ein sicheres Ein- und Ausschalten der Leistungsschalterstruktur mit niedrigen Steuerströmen erreicht wird, wobei die Leistungsschalterstruktur eine hohe Spannungsfestigkeit bei niedrigem Einschaltwiderstand aufweisen soll.

Diese Aufgabe wird durch eine integrierte Leistungsschalterstruktur gemäß Patentanspruch 1 gelöst.

Bevorzugte Weiterbildungen der erfindungsgemäßen Leistungsschalterstruktur sind in den Unteransprüchen angegeben.

Nachfolgend werden unter Bezugnahme auf die beiliegenden Zeichnungen zwei bevorzugte Ausführungsbeispiele der erfindungsgemäßen Leistungsschalterstruktur näher erläutert. Es zeigen:
- Fig. 1: eine erste Ausführungsform einer erfindungsgemäßen integrierten Leistungsschalterstruktur;
- Fig. 2: ein Ersatzschaltbild der in Fig. 1 gezeigten Leistungsschalterstruktur;
- Fig. 3: eine zweite Ausführungsform der erfindungsgemäßen integrierten Leistungsschalterstruktur;
- Fig. 4: ein Ersatzschaltbild der Leistungsschalterstruktur gemäß Fig. 3;
- Fig. 5: einen Leistungs-DMOS-Transistor nach dem Stand der Technik;
- Fig. 6: einen mit einem MOS-Gate gesteuerten Bipolartransistor nach dem Stand der Technik;
- Fig. 7: einen Thyristor mit einem Abschalt-Gate nach dem Stand der Technik;
- Fig. 8: die Abhängigkeit von Stromdichte und Durchlaßspannung bei verschiedenen Leistungsschaltertypen;
- Fig. 9: einen über ein MOS-Gate einschaltbaren bekannten Thyristor;
- Fig. 10: ein Ersatzschaltbild des Thyristors gemäß Fig. 9;
- Fig. 11: einen weiteren, über ein MOS-Gate steuerbaren Thyristor nach dem Stand der Technik; und
- Fig. 12: ein Ersatzschaltbild des Thyristors gemäß Fig. 11.

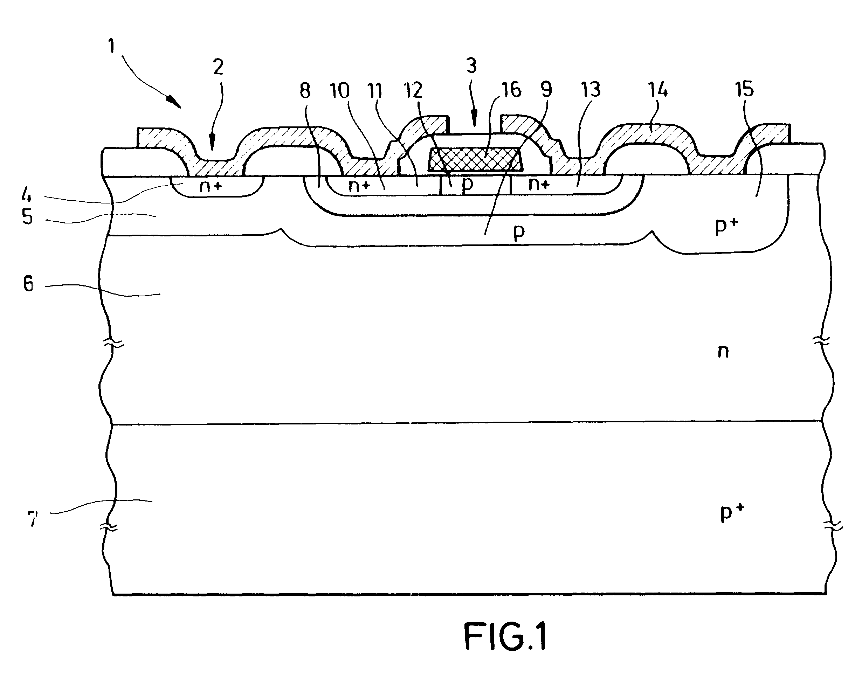

Wie in Fig. 1 gezeigt ist, umfaßt die dort gezeigte Ausführungsform einer erfindungsgemäßen integrierten Leistungsschalterstruktur, die in ihrer Gesamtheit mit dem Bezugszeichen 1 bezeichnet ist, im wesentlichen einen vertikalen Thyristor 2 sowie ein lateraler NMOS-FET mit seinem Gate G3. Der Thyristor 2 hat eine n⁺pnp⁺-Vierschichtstruktur mit einer n⁺-Schicht 4, einer p-Basisschicht 5, einer n-Basisschicht bzw. n-Epi-Schicht 6 und einem p⁺-Substrat 7. Die n⁺-Schicht 4 bildet die Kathode des Thyristors 2, während das p⁺-Substrat 7 dessen Anode darstellt. Durch eine vergrabene, im wesentlichen wannenförmige Oxidschicht 8 ist der laterale MOS-Transistor 3 von der übrigen Leistungsschalterstruktur 4 bis 7 isoliert. Unter der vergrabenen Oxidschicht 8 liegt eine Dotierungsschicht 9, die entgegengesetzt zu der darunterliegenden n-Epi-Schicht 6 dotiert ist und die in die p-Basisschicht 5 des vertikalen Thyristors 2 übergeht.

Die vergrabene Oxidschicht 8 kann durch lokale Hochdosisimplantation von Sauerstoff in das Silizium erzeugt werden. Ein hochqualitatives vergrabenes Oxid wird durch darauffolgende Temperung erhalten. In die darüberliegende Silizium-schicht bzw. Siliziuminsel 10 kann der laterale MOS-Transistor 3 direkt integriert werden. Dieser umfaßt einen n⁺-Bereich 11, der die Drainelektrode bildet. Einen p-Bereich 12, der den Kanal festlegt, sowie einen n⁺-Bereich 13, welcher die Sourceelektrode des NMOS-Transistors 3 darstellt und gleichzeitig die Kathode der aus dem Thyristor 2 sowie MOS-Transistor 3 gebildeten Leistungsschalterstruktur festlegt. Die sich an die Sourceelektrode 13 anschließende Kontaktierung 14 steht ferner mit einem p⁺-Bereich 15 in Verbindung, der an die p-Dotierungsschicht 9 anschließt.

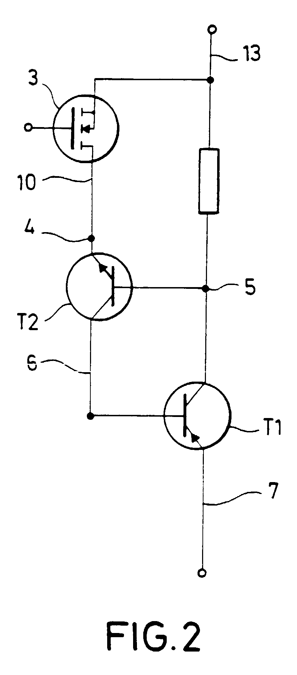

Es ist offensichtlich, daß bei der erfindungsgemäßen Leistungsschalterstruktur die Drain-Source-Strecke 10, 13 des lateralen MOS-Transistors 3 in Serie zu der Kathoden-Anoden-Strecke 4, 5, 6, 7 des Thyristors 2 liegt. Somit wird der Strom direkt geschaltet und nicht nicht indirekt dadurch, daß ein möglichst großer Anteil des Basisstromes des npn-Bipolartransistors T2 kurzgeschlossen wird. Wie insbesondere aus dem Ersatzschaltbild gemäß Fig. 2 zu sehen ist, in dem gleiche Bezugszeichen gleiche Bereiche wie in Fig. 1 bezeichnen, kann bei der erfindungsgemäßen integrierten Leistungsschalterstruktur auch kein parasitärer Thyristor auftreten. Der Sourceanschluß 13 ist dielektrisch vom Substrat isoliert und nicht mehr Bestandteil einer npnp-Vierschichtstruktur 4, 5, 6, 7, die bei einem Zünden ein sicheres Abschalten großer Ströme unmöglich macht. Der Gesamtstrom der erfindungsgemäßen Leistungschalterstruktur muß über den Kanal 12 des lateralen MOS-Transistors 3 fließen und kann von dessen Gate 16 gesteuert werden. Es ist offensichtlich, daß bei der erfindungsgemäßen Leistungsschalterstruktur die Sperrspannung an der Raumladungszone innerhalb der Vierschichtstruktur des Thyristors 2 abfällt, so daß der MOS-Transistor 3 keine hohe Spannungsfestigkeit benötigt. Damit kann der MOS-Transistor mit einem relativ niedrigen Kanalwiderstand ausgeführt werden. Der Einschaltwiderstand der gesamten Leistungsschalterstruktur liegt zwischen demjenigen eines Thyristors und demjenigen eines IGBT. Der Widerstand der Epitaxieschicht ist vernachlässigbar, so daß der Einschaltwiderstand hauptsächlich durch den Kanalwiderstand des MOS-Transistors 3 bestimmt wird, der aus den dargelegten Gründen relativ niedrig sein kann. Da die Spannungsfestigkeit durch die Dotierung und Ausdehnung der Epitaxieschicht 6 festgelegt wird, kann man Leistungsschalter herstellen, die bei 500 V Sperrspannung einen kleineren Einschaltwiderstand als ein IGBT besitzen. Dies trägt bei vorgegebenen Randbedingungen, wie beispielsweise der Einschaltwiderstand oder der zulässigen Verlustleistung, zur Reduktion der Bauelementefläche bei.

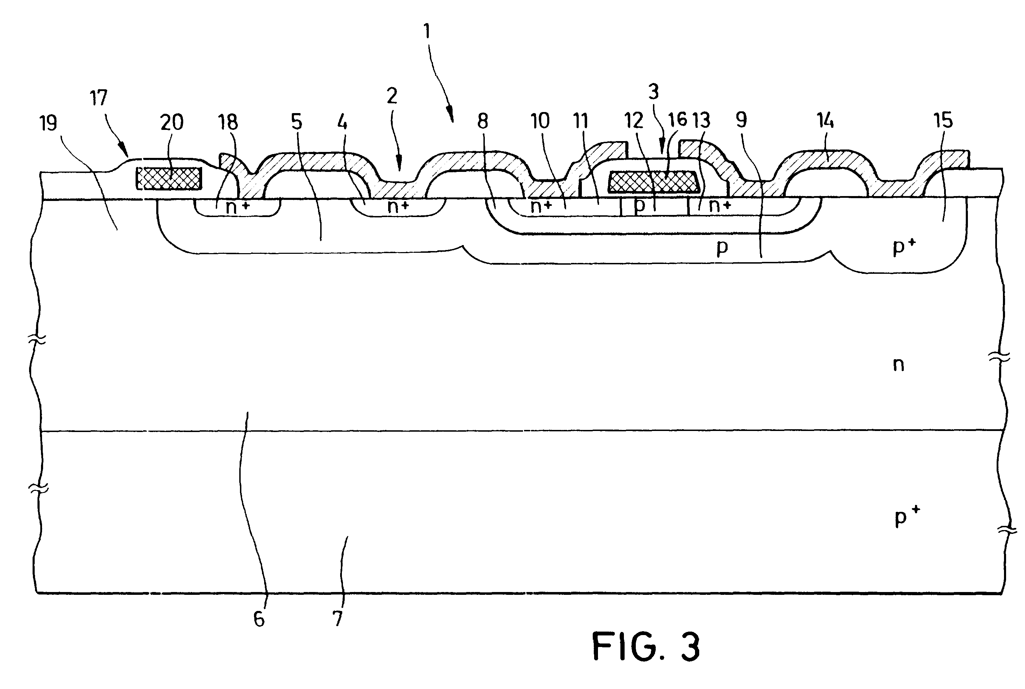

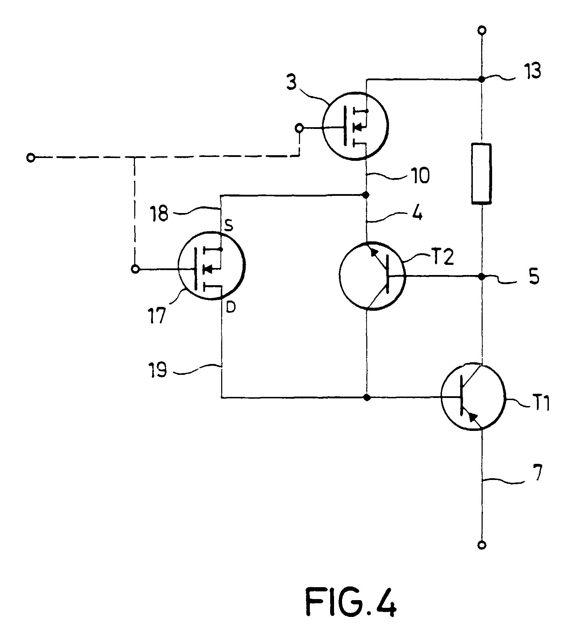

Eine abgewandelte Ausführungsform der erfindungsgemäßen Leistungsschalterstruktur 1 ist in Fig. 3 wiedergegeben. Die Ausführungsform der Leistungsschalterstruktur gemäß Fig. 3 stimmt mit Ausnahme der nachfolgend erläuterten Abweichung mit der derjenigen von Fig. 1 überein, so daß auf eine nochmalige Erläuterung übereinstimmender und mit den jeweils gleichen Bezugszeichen bezeichneter Bereiche verzichtet werden kann. Dementsprechend stimmt auch das Ersatzschaltbild gemäß Fig. 4 mit Ausnahme der nachfolgend erläuterten Abweichung mit demjenigen gemäß Fig. 2 identisch überein.

Bei der Leistungsschalterstruktur gemäß Fig. 3 ist zusätzlich ein weiteres MOS-Gate bzw. ein weiterer MOS-Transistor 17 vorgesehen, dessen Sourceelektrode 18 durch einen n⁺-Bereich innerhalb der p-Basisschicht 5 gebildet wird und dessen Drain 19 in die n-Basisschicht 6 übergeht. Der Kanal des MOS-Transistors 17 wird durch die p-Schicht 5 festgelegt, oberhalb der das Gate 20 des MOS-Transistors 17 liegt. Wie dem Ersatzschaltbild gemäß Fig. 4 zu entnehmen ist, ist vorzugsweise das Gate des lateralen MOS-Transistors 3 mit demjenigen des weiteren MOS-Transistors 17 verbunden.

Das weitere MOS-Gate 17 dient zum Einschalten des Thyristors 2 der Leistungsschalterstruktur 1. Bei positiver Spannung an dem Gate 20 wird ein Kanal aufgesteuert, der ähnlich einem IGBT einen Strom in die n-dotierte Epitaxieschicht 6 injiziert. Wenn, wie dies bei dem Ausführungsbeispiel nach Fig. 3 der Fall ist, das Gate 20 des weiteren MOS-Transistors 17 mit demjenigen 16 des lateralen MOS-Transistors 3 verbunden ist, so kann mit einer einzigen Steuerelektrode der zu steuernde Strom eingeschaltet werden, soweit die Gate-Source-Spannung oberhalb der Schwellenspannung der Transistoren 3 und 17 ist, oder ausgeschaltet werden, wenn diese kleiner als die Schwellenspannung ist.

In Abweichung zu der gezeigten Struktur können auch jeweils inverse Dotierungen verwendet werden.

Ferner ist es möglich, anstelle eines vertikalen Thyristors einen lateralen Thyristor zu verwenden.

## Patentansprüche

1. Mit einer unipolaren Ansteuerspannung ansteuerbare integrierte Leistungsschalterstruktur mit einem von einem lateralen MOS-Transistor (3) gesteuerten lateralen oder vertikalen Thyristor (2), bei der
der Thyristor (2) als Vierschichtthyristor mit einer Anodenschicht (7), einer entgegengesetzt zu der Anodenschicht (7) dotierten ersten Basisschicht (6), einer entgegengesetzt zu der ersten Basisschicht (6) dotierten weiteren Basisschicht (5) und einer Kathodenschicht (4) ausgebildet ist,
der laterale MOS-Transistor (3) mit seiner Drain- Source-Strecke (11, 12, 13) in Reihe zu der Kathoden-Anoden-Strecke (4, 5, 6, 7) des Thyristors (2) im Hauptstromweg der Leistungsschalterstruktur liegt, wobei dessen Drainelektrode (10) mit der Kathode (4) des Thyristors (2) verbunden ist und dessen Sourceelektrode (13) zusammen mit der Anodenschicht (7) des Thyristors den Hauptstromweg der Leistungsschalterstruktur (1) festlegt, und
eine den lateralen MOS-Transistor (3) gegenüber dem Substrat (7) und der ersten Basisschicht (6) isolierende vergrabene Oxidschicht (8) unterhalb der Source-Elektrode (13) angeordnet ist.

2. Integrierte Leistungsschalterstruktur nach Anspruch 1,
dadurch gekennzeichnet,
daß die vergrabene Oxidschicht (8) den lateralen MOS-Transistor (3) wannenartig umschließt.

3. Integrierte Leistungsschalterstruktur nach Anspruch 2,
dadurch gekennzeichnet,
daß der Thyristor (2) eine vertikale npnp-Vierschichtstruktur (4, 5, 6, 7) aufweist,
daß die vergrabene Oxidschicht (8) in der der n-Kathodenschicht (4) benachbarten weiteren p-Basisschicht (5) oder p-dotierten Schicht (9), die sich an die weitere Basisschicht (5) anschließt, liegt, und
daß der laterale MOS-Transistor ein NMOS-Transistor (3) ist.

4. Integrierte Leistungsschalterstruktur nach einem der Ansprüche 1 bis 3, gekennzeichnet durch
einen weiteren MOS-Transistor (17), der derart angeordnet ist, daß bei einer entsprechenden Eingangsspannung an seiner Gate-Elektrode (20) Ladungsträger in die an die Anodenschicht (7) angrenzende erste Basisschicht (6) der npnp-Vierschichtstruktur des Thyristors (2) injiziert werden.

5. Integrierte Leistungsschalterstruktur nach Anspruch 4, dadurch gekennzeichnet,
daß die Gateelektrode (20) des weiteren MOS-Transistors (17) mit der Gateelektrode (16) des lateralen MOS-Transistors (3) verbunden ist.

6. Integrierte Leistungsschalterstruktur nach Anspruch 4 oder 5, dadurch gekennzeichnet,
daß der weitere MOS-Transistor ein NMOS-Transistor (17) ist, dessen Sourceelektrode (18) mit der n⁺-Kathodenschicht (4) des Thyristors (2) verbunden ist und dessen Drainelektrode (19) durch die der Anodenschicht (7) benachbarte erste Basisschicht (6) gebildet wird.

7. Integrierte Leistungsschalterstruktur nach einem der Ansprüche 1 bis 6, dadurch gekennzeichnet,
daß eine entgegengesetzt zu der ersten Basisschicht (6) dotierte Schicht (9) zwischen der vergrabenen Oxidschicht (8) und der ersten Basisschicht (6) vorgesehen ist und die vergrabene Oxidschicht (8) umschließt.

8. Integrierte Leistungsschalterstruktur nach Anspruch 7, dadurch gekennzeichnet,
daß die entgegengesetzt zu der ersten Basisschicht (6) dotierte Schicht (9) in die weitere Basisschicht (5) des Thyristors (2) übergeht.

9. Integrierte Leistungsschalterstruktur nach Anspruch 7 oder 8, dadurch gekennzeichnet,
daß ein entgegengesetzt zu der ersten Basisschicht (6) hochdotierter Bereich (15) an die entgegengesetzt zu der ersten Basisschicht (6) dotierte Schicht (9) angrenzt und mit der Sourceelektrode (13) des lateralen MOS-Transistors (3) verbunden ist.

## Claims

1. An integrated power switch structure drivable by an unipolar driving voltage, which comprises a lateral or a vertical thyristor (2) controlled by a lateral MOS transistor (3), wherein
the thyristor (2) is constructed as a four-layer thyristor comprising an anode layer (7), a first base layer (6) which is doped contrary to the anode layer (7), an additional base layer (5) which is doped contrary to the first base layer (6), and a cathode layer (4),
in the main current path of the power switch structure, the lateral MOS transistor (3) has its drain-source path (11, 12, 13) connected in series with the cathode-anode path (4, 5, 6, 7) of the thyristor (2), the drain electrode (10) of the lateral MOS transistor (3) being connected to the cathode (4) of the thyristor (2) and the source electrode (13) of the lateral MOS transistor (3) defining together with the anode layer (7) of the thyristor the main current path of the power switch structure (1), and
a buried oxide layer (8) insulating the lateral MOS transistor (3) against the substrate (7) and the first base layer (6) is arranged below the source electrode (13).

2. An integrated power switch structure according to claim 1, characterized in
that the buried oxide layer (8) encloses the lateral MOS transistor (3) in a well-like manner.

3. An integrated power switch structure according to claim 2, characterized in
that the thyristor (2) is provided with a vertical npnp four-layer structure (4, 5, 6, 7),
that the buried oxide layer (8) lies in the additional p-base layer (5) bordering on the n-cathode layer (4) or in the p-doped layer (9) bordering on the additional base layer (5), and
that the lateral MOS transistor is an NMOS transistor (3).

4. An integrated power switch structure according to one of the claims 1 to 3, characterized by
an additional MOS transistor (17), which is arranged in such a way that, when an adequate input voltage is applied to its gate electrode (20), charge carriers will be injected into the first base layer (6) of the npnp-four-layer structure of the thyristor (2), the first base layer (6) bordering on the anode layer (7).

5. An integrated power switch structure according to claim 4, characterized in
that the gate electrode (20) of the additional MOS transistor (17) is connected to the gate electrode (16) of the lateral MOS transistor (3).

6. An integrated power switch structure according to claim 4 or 5, characterized in
that the additional MOS transistor is an NMOS transistor (17) whose source electrode (18) is connected to the n+-cathode layer (4) of the thyristor (2) and whose drain electrode (19) is defined by the first base layer (6) bordering on the anode layer (7).

7. An integrated power switch structure according to one of the claims 1 to 6, characterized in
that a layer (9) doped contrary to the first base layer (6) is provided between the buried oxide layer (8) and the first base layer (6), and that the layer (9) encloses the buried oxide layer (8).

8. An integrated power switch structure according to claim 7, characterized in
that the layer (9) doped contrary to the the first base layer (6) merges with the additional base layer (5) of the thyristor (2).

9. An integrated power switch structure according to claim 7 or 8, characterized in
that a region (15), which is highly doped contrary to the first base layer (6), borders on the layer (9) doped contrary to the first base layer (6) and is connected to the source electrode (13) of the lateral MOS transistor (3).

## Revendications

1. Structure de commutateur de puissance intégrée pouvant être commandée par une tension de commande unipolaire, avec un thyristor latéral ou vertical (2) commandé par un transistor MOS latéral (3), dans laquelle
le thyristor (2) se présente sous forme de thyristor à quatre couches avec une couche anodique (7), une première couche de base (6) dopée de manière opposée à la couche anodique (7), une autre couche de base (5) dopée de manière opposée à la première couche de base (6) et une couche cathodique (4),
le transistor MOS latéral (3) se trouve, par son trajet décharge-source (11, 12, 13) en série avec le trajet cathode-anode (4, 5, 6, 7) du thyristor (2) sur le chemin de courant principal de la structure de commutateur de puissance, son électrode de décharge (10) étant reliée à la cathode (4) du thyristor (2) et son électrode de source (13) déterminant, ensemble avec la couche anodique (7) du thyristor, le chemin de courant principal de la structure de commutateur de puissance (1), et
une couche d'oxyde (8) enterrée isolant le transistor MOS latéral (3) par rapport au substrat (7) et à la première couche de base (6) est disposée au-dessous de l'électrode de source (13).

2. Structure de commutateur de puissance intégrée suivant la revendication 1, caractérisée par le fait que la couche d'oxyde (8) enterrée entoure le transistor MOS latéral (3) sous forme de cuvette.

3. Structure de commutateur de puissance intégrée suivant la revendication 2, caractérisée par le fait
que le thyristor (2) présente une structure verticale à quatre couches npnp (4, 5, 6, 7),
que la couche d'oxyde (8) enterrée se trouve dans l'autre couche de base p (5) adjacente à la couche cathodique n (4) ou dans la couche dopée p (9) suivant l'autre couche de base (5), et
que le transistor MOS latéral est un transistor NMOS (3).

4. Structure de commutateur de puissance intégrée suivant l'une des revendications 1 à 3, caractérisée par un autre transistor MOS (17) qui est disposé de sorte qu'en cas de tension d'entrée correspondante à son électrode de déclenchement (20) sont injectés des porteurs de charge dans la première couche de base (6), adjacente à la couche anodique (7), de la structure à quatre couches npnp du thyristor (2).

5. Structure de commutateur de puissance intégrée suivant la revendication 4, caractérisée par le fait que l'électrode de déclenchement (20) de l'autre transistor MOS (17) est reliée à l'électrode de déclenchement (16) du transistor MOS latéral (3).

6. Structure de commutateur de puissance intégrée suivant la revendication 4 ou 5, caractérisée par le fait que l'autre transistor MOS est un transistor NMOS (17) dont l'électrode de source (18) est reliée à la couche cathodique n⁺ (4) du thyristor (2) et dont l'électrode de décharge (19) est constituée par la première couche de base (6) adjacente à la couche anodique (7) .

7. Structure de commutateur de puissance intégrée suivant l'une des revendications 1 à 6, caractérisée par le fait qu'entre la couche d'oxyde (8) enterrée et la première couche de base (6) est prévue une couche dopée (9) de manière opposée à la première couche de base (6) et qui entoure la couche d'oxyde (8) enterrée.

8. Structure de commutateur de puissance intégrée suivant la revendication 7, caractérisée par le fait que la couche dopée (9) de manière opposée à la première couche de base (6) passe dans l'autre couche de base (5) du thyristor (2).

9. Structure de commutateur de puissance intégrée suivant la revendication 7 ou 8, caractérisée par le fait qu'une zone hautement dopée (15) de manière opposée à la première couche de base (6) est adjacente à la couche dopée (9) de manière opposée à la première couche de base (6) et est reliée à l'électrode de source (13) du transistor MOS latéral (3).
